Europäisches Patentamt

European Patent Office

Office européen des brevets

(11) Veröffentlichungsnummer: **0 327 809**
A2

## (12) EUROPÄISCHE PATENTANMELDUNG

(21) Anmeldenummer: **89100287.5**

(51) Int. Cl.⁴: **G12B 9/00 , H05K 5/00**

(22) Anmeldetag: **10.01.89**

(30) Priorität: **12.02.88 CH 521/88**

(43) Veröffentlichungstag der Anmeldung:
**16.08.89 Patentblatt 89/33**

(84) Benannte Vertragsstaaten:
**DE FR GB IT NL SE**

(71) Anmelder: **EDAK AG**
**Rheinauerweg 481**
**CH-8447 Dachsen(CH)**

(72) Erfinder: **Ess, Emil**
**Scheibeneckerstrasse 12**
**CH-8245 Feuerthalen(CH)**

(74) Vertreter: **Willi, Anton, J.**
**Alsenmattstrasse 2**
**CH-8800 Thalwil(CH)**

(54) **Tragbares Schutzgehäuse für elektrische und elektronische Geräte.**

(57) Im metallischen Gehäusemantel (1) ist mittels Schwingungsdämpfern (9) ein Aufnahmerahmen (10) für das Gerät aufgehängt. Ein Randflansch (4) des Gehäusemantels (1) ist durch eine metallische Abschirmung (15), z.B. ein Metalldrahtnetz oder Gewebe oder eine Folie, mit einem Randflansch (11) des Aufnahmerahmens (10) elektrisch leitend verbunden. Die gegenüber dem Abstand der beiden je mit einem Dichtungsring (14, 15) versehenen Randprofile (4, 11) Ueberlänge aufweisende und entsprechend ausgebauchte Abschirmung (14) verhindert auch bei abgenommenem Deckel (3) elektromagnetische Ein- und Ausstrahlungen in den bzw. aus dem Innenraum des Gehäusemantels (1) ohne Schwingbewegungen des Aufnahmerahmens (10) zu behindern.

Fig 1

## Tragbares Schutzgehäuse für elektrische und elektronische Geräte

Gegenstand der vorliegenden Erfindung ist ein tragbares Schutzgehäuse für elektrische und elektronische Geräte. Es ist bekannt, solche Geräte, wenn sie z.B. für militärische, Forschungs oder ähnliche Zwecke bei extremer mechanischer und/oder klimatischer Beanspruchung eingesetzt werden müssen in vibrationsfesten kastenförmigen Gehäusen unterzubringen. Ueblicherweise besitzen diese Schutzgehäuse einen selbsttragenden, kastenförmigen metallischen Gehäusemantel mit durch einen Metalldeckel abschliessbarer Frontöffnung, in welchen Gehäusemantel ein an Schwingungsdämpfern aufgehängter metallischer Aufnahmerahmen für das durch die Mantelfrontöffnung ein- und ausbaubare Gerät angeordnet ist, wobei ein Randprofil des Mantels einerseits und ein Randprofil des Aufnahmerahmens anderseits je einen Dichtungsring trägt.

In vielen Fällen hat es sich als nachteilig erwiesen, dass zwar die Frontöffnung des Gehäusemantels mittels des Deckels eine einwandfreie elektrische Abschirmung bildet (Faradayscher Käfig), bei abgenommenem Deckel aber, d.h. also bei zur Benützung zugänglichem Gerät, der Mantelinnenraum nicht mehr abgeschirmt ist, sodass unerwünschte elektrische bzw. elektromagnetische Ein- und/oder Ausstrahlungen erfolgen können.

Erfindungsgemäss wird dieses Problem dadurch gelöst, dass das Randprofil, das den die Frontöffnung des Gehäusemantels umschliessenden ersten Dichtungsring trägt, und das Randprofil, das den die Geräteeinschuböffnung des Aufnahmerahmens umschliessenden zweiten Dichtungsring trägt, durch eine den Frontspalt zwischen Gehäusemantel- und Aufnahmerahmen überspannende und Schwingbewegungen des Aufnahmerahmens durch entsprechende Deformation zulassende metallische oder andere leitende Abschirmung miteinander elektrisch verbunden sind.

Damit ist auch bei abgenommenem Deckel der Zwischenraum zwischen Mantel und Rahmen gegen unerwünschte elektrische bzw. elektromagnetische Ein- bzw. Ausstrahlungen abgeschlossen. Besonders vorteilhafte Ausführungsformen der Erfindung sind in den Ansprüchen 2 bis 5 aufgeführt.

Anhand der beiliegenden Zeichnung ist die Erfindung im folgenden beispielsweise näher erläutert. In der Zeichnung zeigt

Fig. 1 einen Querschnitt durch einen Teil der Frontpartie des Gehäuses bei abgehobenem Deckel (ohne das einzusetzende Gerät),

Fig. 2 und 3 einen Querschnitt durch eine Längsseite bzw. eine Schmalseite der im Grundriss rechteckförmigen Abschirmung gemäss Fig. 1 mit zugeordneten Dichtungsringen vor deren Einsatz in das Traggehäuse

Fig. 4 und 5 einen Querschnitt durch eine Längsseite je einer Variante der Abschirmung nach Fig. 2.

Das gezeichnete Schutzgehäuse besitzt einen kastenförmigen, selbsttragenden Metallmantel 1 mit mittels versenkter Griffbolzen 2 am Mantel fixierbarem Frontdeckel 3. Ein Randprofil 4 des Mantels 1 ist frontseitig mit einer Umfangsnut versehen, die nach innen von einem überstehenden Flansch 4a begrenzt ist. Am Randprofil 4 sind ferner nicht gezeichnete Eingriffsplatten 8 für die Griffbolzen 2 befestigt, die durch an einem Randprofil 6 des Deckels 3 befestigte Winkelplatten 7 hindurchführen. Im Metallmantel 1 und im Wandabstand zu diesem ist mittels acht Schwingungsdämpfern 9 ein metallischer Aufnahmerahmen 10 aufgehängt. Der bezüglich Aufnahmeraum genormte Aufnahmerahmen 10 ist von seiner gegenüber der Offenseite des Mantels 1 zurückversetzten Frontseite her mit den jeweiligen Einbaugeräten bestückbar. Er besitzt ein Randprofil 11, das an den Längsseiten eine Nut aufweist, die nach innen von einem überstehenden Flansch 11a begrenzt ist; die einen Flansch 12 bildenden Schmalseiten des Randprofils 11 dagegen sind mit einer Reihe von Löchern 12a versehen. An der Unterseite des Schmalseitenflansches 12 des Randprofils 11 ist mittels Schrauben 13b eine Gewindeleiste 13 befestigt, deren Gewindebohrungen 13a mit den Löchern 12a des Schmalseitenflansches 12 fluchten.

In die Rechteckquerschnitt aufweisende, umlaufende Nut des Randprofils 4 des Gehäusemantels 1 ist ein Dichtungsring 14 eingepasst. Ein entsprechender Dichtungsring 16 ist in die ebenfalls umlaufende Nut des Randprofils 11 des Aufnahmerahmens 10 eingesetzt. Der Zwischenraum zwischen den beiden Randprofilen 4 und 10 ist von einer metallischen Abschirmung 15 überspannt, die durch ein Gewebe oder ein engmaschiges Netz gebildet ist. Diese Abschirmung 15 ist mit ihren die Dichtungsringe 14, 16 in der entsprechenden Nut untergreifenden Randpartien durch diese fest eingepressten Dichtungsringe mit den Randprofilen 4 und 10 und damit mit dem Gehäusemantel 1 und dem Aufnahmerahmen 10 elektrisch leitend verbunden.

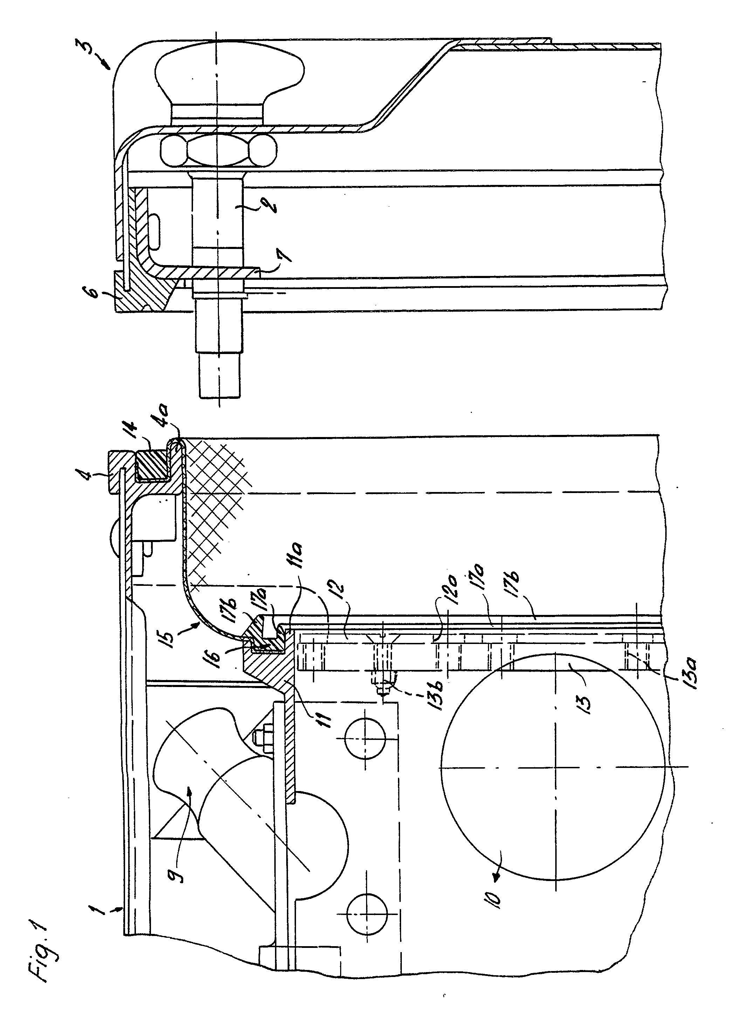

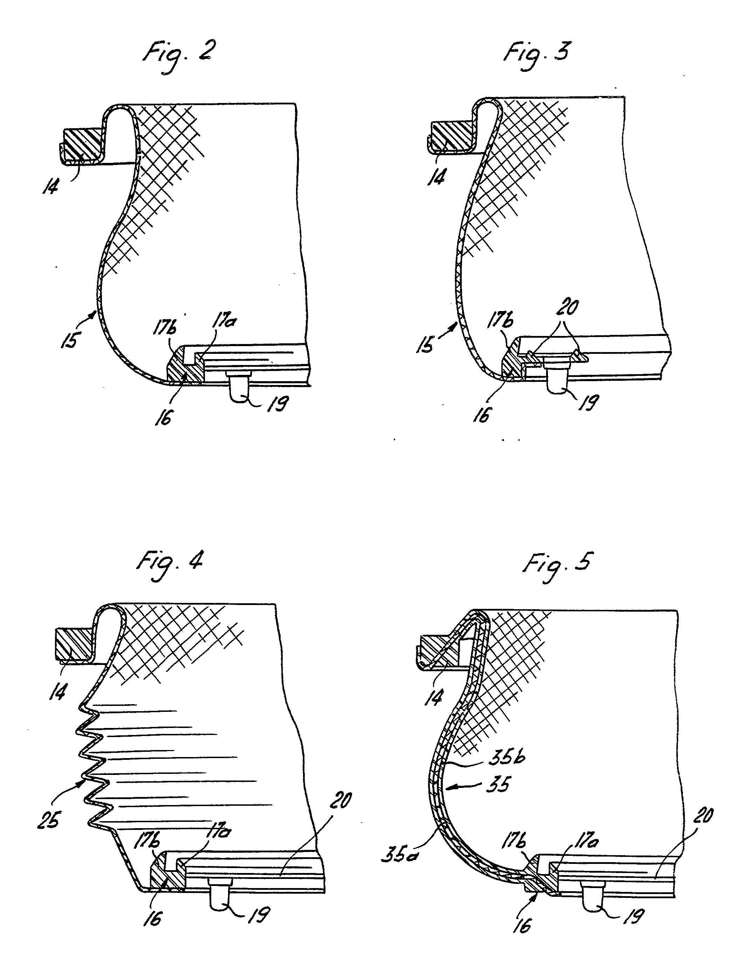

Wie aus Fig. 1 ersichtlich, schliesst die Abschirmung 15 den Spaltraum zwischen Gehäusemantel 1 und Aufnahmerahmen 10 einwandfrei nach aussen ab. Nun kann wie üblich das gewünschte Gerät (nicht gezeichnet) in den Aufnahmerahmen 10 eingeschoben und mit dem überstehenden Rand seiner der Normung des Aufnahmerahmens entsprechenden Frontplatte auf dem Dichtungring 15 allseitig aufliegend mittels Schrauben an der Gewindeleiste 13 fixiert werden. Damit ist nicht nur der Spaltraum zwischen Mantel und Aufnahmerahmen, sondern auch die Einschuböffnung des Aufnahmerahmens 10 und somit das eingebaute Gerät einwandfrei elektrisch abgeschirmt. Die dank der Ueberlänge (Fig. 2 und 3) ausgebauchte Abschirmung behindert in keiner Weise die infolge der schwingungsdämpfenden Aufhängung des Aufnahmerahmens 10 etwa auftretenden Relativbewegungen von Gehäusemantel 1 und Aufnahmerahmen 10, da diese stets relativ kleinen Bewegungen die Abschirmung an keiner Stelle zu strecken bzw. unzulässig zu dehnen vermögen. Das Gerät ist somit nicht nur bei aufgesetztem Deckel 3 elektrisch abgeschirmt und vibrationsfest im Gehäusemantel 1 untergebracht, sondern auch bei abgenommenem Deckel, d.h. im Betriebszustand, dank der Abschirmung 15 gegen elektromagnetische Ein- und Ausstrahlungen einwandfrei geschützt.

Wie die Fig. 2 und 3 zeigen, können die Ränder der als Rechteckschlauch ausgebildeten Abschirmung 15 schon vor deren Einbau mit den z.B. aus Gummi bestehenden Dichtungsringen 14 und 16 verbunden werden. Sofern die Abschirmung 15 nicht selbst schon als Dichtung gegen Feuchtigkeit und Staub genügt, kann sie ein- oder beidseitig mit einem geeigneten Dichtungsmaterial z.B. Kunststoff oder Gummi beschichtet sein, sofern darauf geachtet wird, dass die elektrisch leitende Verbindung der Abschirmung mit den Randprofilen 4 und 11 erhalten bleibt.

Während beim vorangehend beschriebenen Beispiel die Abschirmung 15 als durch ein Metalldrahtgewebe oder Netz gebildet angenommen wurde, das sich dank seiner allseitigen leichten Verformbarkeit zur Zulassung von Schwingbewegungen des Aufnahmerahmens besonders gut eignet, könnte die Abschirmung, wie bei 25 in Fig. 4 gezeigt, auch durch eine Metallfolie gebildet sein. Diese kann zur Schaffung der notwendigen Ueberlänge gegenüber dem Abstand der beiden Randprofile 4 und 11 und zur ein unerwünschtes Einbeulen verhindernden Versteifung mit einer zickzackartigen Faltung versehen sein.

Eine weitere Variante ist in Fig. 5 dargestellt. Hier bilden die Dichtungsringe 14 und 16 mit der metallischen Abschirmung 35a eine Einheit. Die Abschirmung 35a liegt dabei eingebettet in einem die beiden Dichtungsringe 14, 16 einstückig miteinander verbindenden Dichtungsbalg 35b, wobei die Endpartien der Abschirmung 35a aus den beiden Dichtungsringen 14, 16 herausgeführt sind und bei eingesetzter Dichtungseinheit 14, 35b, 16 die elektrische Verbindung der Abschirmung mit den Randprofilen 4, 11 gewährleisten. Es versteht sich, dass auch in diesem Fall die Abschirmung 35a durch ein Netz oder ein Gewebe aus Metalldraht oder durch eine Metallfolie gebildet sein kann.

Zweckmässig besteht die metallische Abschirmung aus einem elektrisch gut leitenden Material wie z.B. Aluminium, Kupfer oder einer entsprechenden Legierung. Es kann in gewissen Fällen aber auch eine Stahlabschirmung oder eine aus einem nicht metallischen, mit einem galvanischen Ueberzug versehenen Trägermaterial bestehende Abschirmung vorgesehen sein.

Während bei den vorangehend beschriebenen Ausführungsformen die elektrisch leitende Abschirmung stets die beiden Dichtungsringe 14 und 16 miteinander verbindet und durch diese in leitender Verbindung mit den metallischen Randprofilen gehalten ist, könnten die Endpartien der Abschirmung auch unabhängig vom einen oder beiden Dichtungsringen direkt mit den Randprofilen 4 bzw. 11 elektrisch leitend verbunden sein. Wesentlich ist nur, dass sie dabei auch bei abgenommenem Deckel den Zwischenraum zwischen den beiden Randprodilen so überspannt, dass durch Bildung eines Faradayschen Käfigs eine einwandfreie elektrische bzw. elektromagnetische Abschirmung gewährleistet ist und gleichzeitig Schwingbewegungen des Aufnahmerahmens ungehindert zulässt ohne dabei selbst unerwünschten mechanischen Belastungen ausgesetzt zu sein.

## Ansprüche

1. Tragbares Schutzgehäuse für elektrische und elektronische Geräte, mit einem selbsttragenden, kastenförmigen metallischen Gehäusemantel (1) mit durch einen Metalldeckel (3) abschliessbarer Frontöffnung, in welchen Gehäusemantel (1) ein an Schwingungsdämpfern (9) aufgehängter metallischer Aufnahmerahmen (10) für das durch die Mantelfrontöffnung ein- und ausbaubare Gerät angeordnet ist, wobei ein Randprofil (4) des Mantels (1) einerseits und ein Randprofil (11) des Aufnahmerahmens (10) anderseits je einen Dichtungsring (14 bzw. 16) trägt, dadurch gekennzeichnet, dass das Randprofil (4) das den die Frontöffnung des Gehäusemantels (1) umschliessenden ersten Dichtungsring (14) trägt, und das Randprofil (11), das den die Geräteeinschuböffnung des Aufnahmerahmens (10) umschliessenden zweiten Dichtungsring (16) trägt, durch eine den Frontspalt zwischen Gehäusemantel (1) und Aufnahmerahmen (10) überspannende und Schwingbewegungen des Aufnahmerahmens (10) durch entsprechende Deformation zulassende elektrisch leitende Abschirmung (15; 25; 35b) miteinander elektrisch leitend verbunden sind.

2. Schutzgehäuse nach Anspruch 1, dadurch gekennzeichnet, dass die Abschirmung (15; 25; 35a) ein Drahtgewebe oder ein Drahtnetz oder eine Folie ist, und gegenüber dem Abstand ihrer Verbindungsstellen mit den Randprofilen (4, 11) Ueberlänge aufweist und gegen den Mantel (1) hin ausgebaucht ist.

3. Schutzgehäuse nach Anspruch 2, dadurch gekennzeichnet, dass die Abschirmung (15; 35a; 25) mit ihren Randpartien die Dichtungsringe (14, 16) unter- oder durchgreifend mit diesen in Nuten der Randprofile (4, 11) gepresst oder sonstwie mechanisch verbunden und dadurch in elektrisch leitender, fester Verbindung mit dem Mantel (1) und dem Aufnahmerahmen (10) gehalten ist.

4. Schutzgehäuse nach Anspruch 2 oder 3, dadurch gekennzeichnet, dass der den Frontspalt überspannende Teil der aus Metall bestehenden Abschirmung (15; 25; 35a) ein- oder beidseitig mit Dichtungsmaterial z.B. Gummi oder Kunststoff beschichtet ist.

5. Schutzgehäuse nach Anspruch 1, dadurch gekennzeichnet, dass die Abschirmung ein einen elektrisch leitenden galvanischen Ueberzug aufweisender Träger, z.B. ein Textilgewebe, ein Netz oder eine Kunststoffolie ist.

Fig.1

EP 0 327 809 A2

Fig. 2

Fig. 3

Fig. 4

Fig. 5